# EUROPEAN PATENT SPECIFICATION

(11) **EP 3 314 635 B1**
(45) Date of publication and mention of the grant of the patent: **30.08.2023**
(21) Application number: 15897299.2
(22) Date of filing: 27.06.2015
(51) Int. Cl.: H01L 21/3205, H01L 21/336, H01L 21/28, H01L 29/08, H01L 21/285, H01L 29/417, H01L 29/45

(54) **METHOD TO FORM OHMIC CONTACTS TO SEMICONDUCTORS USING QUANTIZED METALS**
VERFAHREN ZUR HERSTELLUNG VON OHMSCHEN KONTAKTEN ZU HALBLEITERN MIT QUANTISIERTEN METALLEN
PROCÉDÉ POUR LA FORMATION DE CONTACTS OHMIQUES À DES SEMI-CONDUCTEURS AU MOYEN DE MÉTAUX QUANTIFIÉS

(43) Date of publication of application: 02.05.2018
(73) Proprietor: INTEL Corporation, Santa Clara, CA 95054 (US)
(72) Inventor: CHU-KUNG, Benjamin, Portland, Oregon 97229 (US); LE, Van H., Beaverton OR 97007 (US); RIOS, Rafael, Austin, Texas 78736 (US); DEWEY, Gilbert, Beaverton OR 97006 (US); CLENDENNING, Scott B., Portland, Oregon 97225 (US); KAVALIEROS, Jack T., Portland, Oregon 97229 (US)
(74) Representative: HGF
(86) International application number: PCT/US2015/038191
(87) International publication number: WO 2017/003408

(56) References cited:
- EP-A1- 0 838 862
- EP-A2- 2 701 196
- JP-A- 2001 313 342
- JP-A- 2006 024 809
- US-A1- 2006 266 995
- US-A1- 2007 126 021
- US-A1- 2010 090 289
- US-A1- 2011 168 979
- US-A1- 2013 270 654

## Description

### BACKGROUND

### Field

Integrated circuit devices.

### Description of Related Art

Integrated circuit devices often employ metal to semiconductor contacts. One example is a contact to a junction region (source or drain region) of a transistor device.

While metal is deposited onto a semiconductor material, the dangling bonds at the semiconductor surface makes it such that the Fermi level of the metal and semiconductor material do not match. The result is a pinning of the Fermi level in a semiconductor to a particular level (a level in a bandgap) which creates a barrier for carriers to travel through. As metal to semiconductor contact areas and integrated circuit devices gets smaller, the resistance associated with such contact area gets larger (contact resistance is proportional into the inverse of the contact area). Thus, the contact resistance becomes a larger percentage of the overall parasitics of a device. Solutions to address contact resistance include creating a less reactive contact and lowering a bandgap interfacial contact or the use of a lower bandgap interfacial contact layer.

Document EP 2701196 discloses a semiconductor device which includes a semiconductor substrate having a channel region therein, a gate structure above the channel region, and source and drain regions on opposite sides of the gate structure.

Document US 20100090289 discloses semiconductor transistor devices and asociated fabrication teschniques that can be utilised to form silicide contacts having an increaed effective size, relative to convnetional silicide contacts.

Document JP 2006024809 discloses a semiconductor apparatus having a structure capable of supressing a leakage current entailed by a pn-junctinon leakage, and to provide its manufacturing method.

Document EP 0 838 862 A1 discloses a semiconductor device with trench isolation including silicide layers covering the side wall portions of a device region exposed in contact holes.

### BRIEF DESCRIPTION OF THE DRAWINGS

**Figure 1** shows the embodiment of a cross-sectional side view of a transistor device having metal contacts to junction regions of the device.
**Figure 2** shows a portion of the transistor device of **Figure 1** and a corresponding band structure.
**Figure 3** shows a cross-sectional side view of a portion of another embodiment of a transistor device, not forming part of the invention, with a contact to a junction region and a metal/semiconductor material interface having a conical shape.
**Figure 4** shows a cross-sectional side view of a portion of another embodiment of a transistor device, not forming part of the invention, with a dielectric material confining a contact to a junction region.
**Figure 5** shows another embodiment of a portion of a transistor, not forming part of the invention, with a metal contact directly connected (directly in contact with) a channel of the device.
**Figure 6** is an interposer implementing one or more embodiments.
**Figure 7** illustrates an embodiment of a computing device.

### DETAILED DESCRIPTION

Techniques for reducing a contact resistance at a metal to semiconductor interface (a metal to semiconductor contact) are presented and as are transistor devices employing such techniques. In one embodiment, a contact resistance between a metal and a semiconductor material is reduced by grading a metal/semiconductor material interface to smooth out a band discontinuity. In one embodiment, the grading is achieved by confining (e.g., quantizing) a low density of states metal with the metal being more confined (e.g., more quantized) toward the semiconductor.

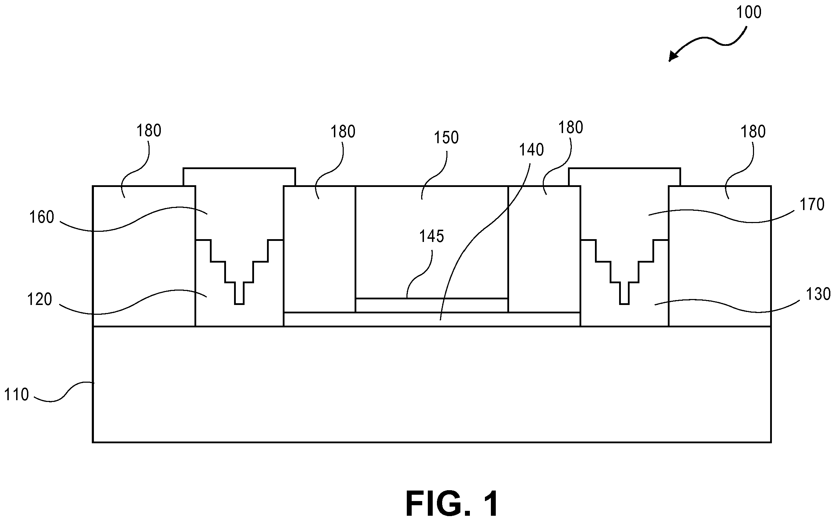

**Figure 1** shows a cross-sectional side view of an embodiment of a transistor device having metal contacts formed to junction regions of the device. Referring to **Figure 1****,** device structure 100 includes substrate 110 of a semiconductor material such as silicon, silicon germanium, germanium, a III-V, or a II-VI compound semiconductor. Disposed on substrate 110 is a transistor device including junction region 120 (e.g., a source), junction region 130 (e.g., a drain), channel 140 between the source and drain, gate dielectric 145 and gate electrode 150 on channel 140. Dielectric material 180 surrounds components of the device structure. In an embodiment where a transistor device is a field effect transistor (single or multi-gate transistor), junction region 120 and junction region 130 are a semiconductor material such as a doped silicon, silicon germanium, germanium, a III-V, or a II-VI compound semiconductor. In one embodiment, for a p-type device, junction region 120 and junction region 130 are each, for example, p⁺ silicon germanium or p⁺ silicon.

**Figure 1** shows metal contacts to each of junction region 120 and junction region 130. According to the invention, a material of metal contact 160 and metal contact 170 to the respective junction regions is a low density of states metal. Low density of states metals according to the invention are antimony (Sb), bismuth (Bi), tin (Sn) and their alloys. These metals may be deposited by physical line of sight methods such as evaporation or sputtering or chemical means such as chemical vapor deposition (CVD) and atomical layer deposition (ALD). Chemical thin film deposition techniques include but are not limited to the use of a volatile metal chloride such as SbCl₃ or SnCl4 as one precursor along with a coreactant such as hydrogen plasma or a homometal silyl coreactant such as Sb(SiR₃)₃ or Sn(SiR₃)₄ or Sn(SiR₃)₂, where R is an organic substituent including but not limited to methyl, ethyl, isopropyl, butyl or phenyl. In order to achieve a void free contact fill, the metal may or may not be annealed under an inert or reducing atmosphere such as one containing hydrogen. **Figure 1** shows the interface between the metal contact and semiconductor material of the junction (contact 160/junction region 120 and contact 170/junction region 130) as graded in the sense that the metal is increasingly confined by semiconductor material. **Figure 1** shows the metal to semiconductor material interface having a profile such that, proceeding in a direction toward substrate 110, the contact area between semiconductor material and metal taken through a horizontal cross-section of the interface (as viewed) gets progressively smaller. Such confinement tends to quantize a metal of the contact.

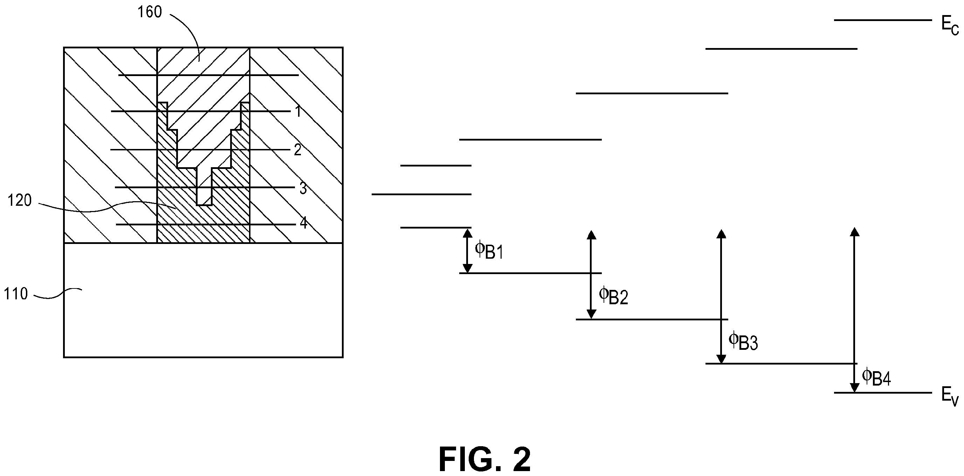

**Figure 2** shows a portion of the transistor device and a corresponding bandgap. **Figure 2** shows that the grading of the metal/semiconductor material interface to progressively confine (e.g., quantize) the metal results in a grading of the band discontinuity. **Figure 2** illustrates a barrier height at a first position (position 1) where a cross-sectional contact area between the metal and semiconductor material is dominated by metal material (least confined metal state) has a barrier height between a valence band and the metal work function. At a cross-section through the contact semiconductor material interface at a position 2, the metal material is becoming more confined by the semiconductor material resulting in a barrier height Φ_{B2}; at a position 3 even more confined resulting in the barrier height illustrated as Φ_{B3}; and finally at position 4 of only semiconductor material having a barrier height Φ_{B4}. Contact resistance is exponetially proportional to barrier height by the representation R=e^{Φ_{B}•k}. By breaking the barrier height into different sub-components (Φ_{B1}, Φ_{B2}, Φ_{B3} and Φ_{B4}), the resistance is reduced as e^{Φ_{B1}•k} + e^{Φ_{B2}•k} + e^{Φ_{B3}•k} + e^{Φ_{B4}•k} is less than e <PB 0 k.

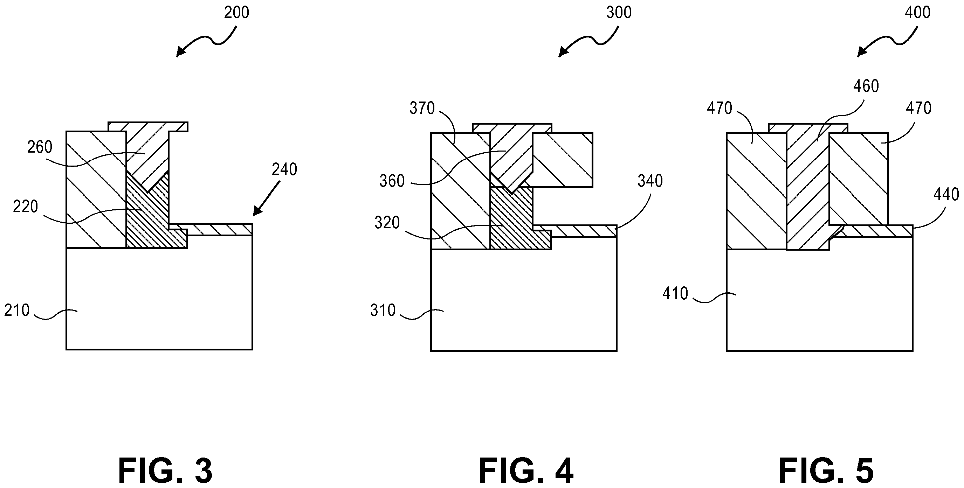

In the above embodiment, the interface between a metal and a semiconductor material is shown as graded or stepped. It is appreciated that other profiles of confinement not forming part of the invention are also disclosed. **Figure 3** shows a cross-sectional side view of a portion of another embodiment of a transistor device, not forming part of the invention.

Device 200 includes junction region 220 (e.g., a source or drain) at channel 240 on substrate 210 with metal contact 260 to junction region 220. **Figure 3** shows an interface having a conical shape. Either the graded interface (**Figure 1**) or the conical interface of **Figure 3** may be formed by an etching process into the junction region material followed by metal deposition. In another embodiment, such a conical or stepped etch profile need not be precise (e.g., because of an etch recipe or tool property) but is suitable to the extent that the low density of states metal is confined (e.g., quantized) in a contact with a profile such as contact 260 or contact 160.

**Figure 4** shows a cross-sectional side view of a portion of another embodiment of a transistor device, not forming part of the invention.

**Figure 4** shows transistor device 300 including junction region 320 (e.g., a source or drain) and channel 340 on substrate 310. **Figure 4** also shows contact 360 to junction region 320. In this embodiment, contact 360 of, for example, a low density of states metal is confined by dielectric material 370. A dielectric material such as deposited silicon dioxide is a high bandgap material which as it confines the metal will reflect a band structure similar to that shown in **Figure 2** As illustrated, a cross-sectional area of metal contact 360 is reduced, in this embodiment, in a conical way in a direction toward junction region 320. In another embodiment, the confinement of metal contact 360 in a direction toward semiconductor material 320 can have other profiles including a step profile for a regular profile that similarly confines (e.g., quantizes) a metal material.

**Figure 5** shows another embodiment of a portion of a transistor device, not forming part of the invention. Device 400 includes channel 440 formed on substrate 410 and metal contact 460 directly contacted to channel 440. In other words, a junction region (source or drain) of, for example, semiconductor material is removed and metal directly contacts channel 440 of the transistor device. As illustrated, contact 460 is defined through dielectric layer 470. As the metal contacts channel 440, the metal is confined by dielectric layer 470 at channel 440. Each of dielectric layer 470 and a low doped semiconductor material for channel 440 is a high bandgap material. The high bandgap will tend to increase the barrier. Thus, increasing a confinement of the metal, in this case, in a direction toward channel 440 will have a tendency to smooth out for junction and reduce a contact resistance.

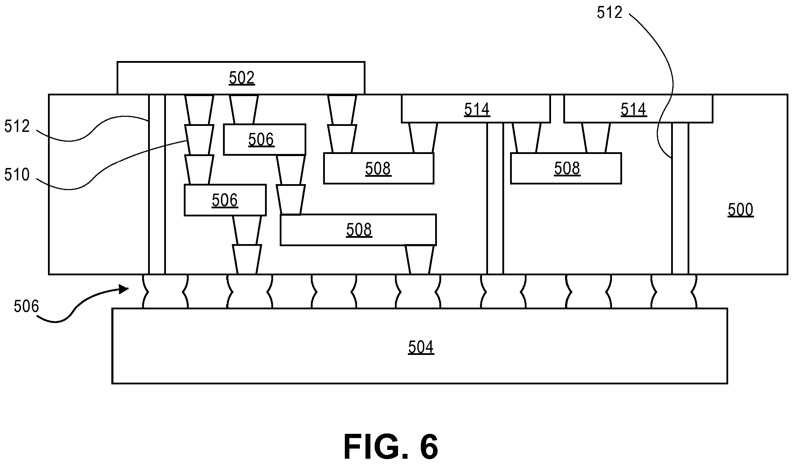

**Figure 6** illustrates interposer 500 that includes one or more embodiments. Interposer 500 is an intervening substrate used to bridge first substrate 502 to second substrate 504. First substrate 502 may be, for instance, an integrated circuit die. Second substrate 504 may be, for instance, a memory module, a computer motherboard, or another integrated circuit die. Generally, the purpose of interposer 500 is to spread a connection to a wider pitch or to reroute a connection to a different connection. For example, interposer 500 may couple an integrated circuit die to ball grid array (BGA) 506 that can subsequently be coupled to second substrate 504. In some embodiments, first and second substrates 502/504 are attached to opposing sides of interposer 500. In other embodiments, the first and second substrates 502/504 are attached to the same side of interposer 500. In further embodiments, three or more substrates are interconnected by way of interposer 500.

Interposer 500 may be formed of an epoxy resin, a fiberglass-reinforced epoxy resin, a ceramic material, or a polymer material such as polyimide. In further implementations, the interposer may be formed of alternate rigid or flexible materials that may include the same materials described above for use in a semiconductor substrate, such as silicon, germanium, and other group III-V and group IV materials.

The interposer may include metal interconnects 508 and vias 510, including but not limited to through-silicon vias (TSVs) 512. The interposer 500 may further include embedded devices 514, including both passive and active devices. Such devices include, but are not limited to, capacitors, decoupling capacitors, resistors, inductors, fuses, diodes, transformers, sensors, and electrostatic discharge (ESD) devices. More complex devices such as radio-frequency (RF) devices, power amplifiers, power management devices, antennas, arrays, sensors, and MEMS devices may also be formed on interposer 500.

In accordance with embodiments, apparatuses or processes disclosed herein may be used in the fabrication of interposer 500.

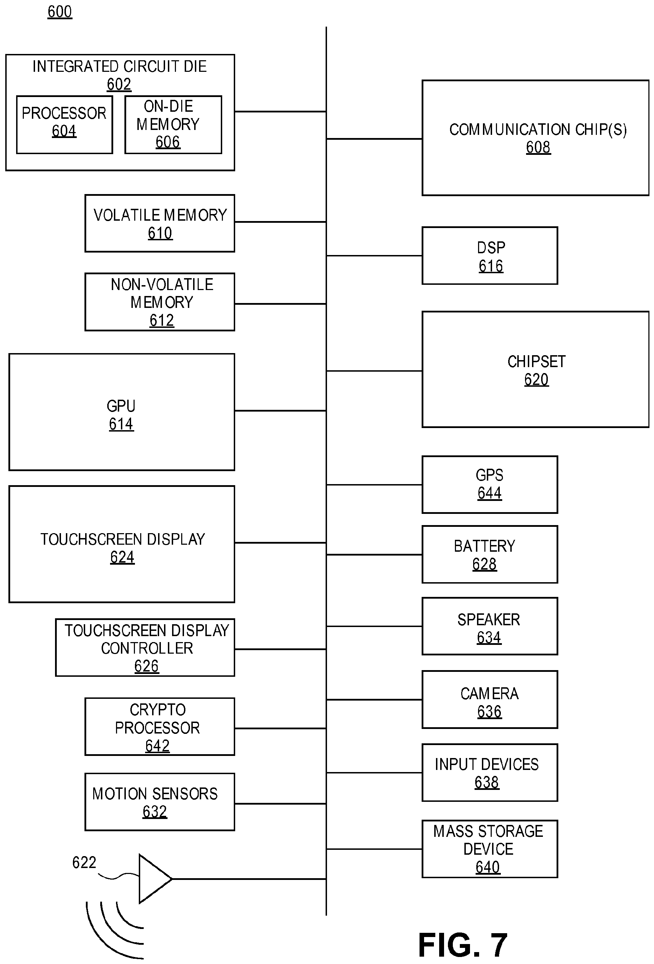

**Figure 7** illustrates a computing device in accordance with one embodiment. Computing device 600 may include a number of components. In one embodiment, these components are attached to one or more motherboards. In an alternate embodiment, these components are fabricated onto a single system-on-a-chip (SoC) die rather than a motherboard. The components in computing device 600 include, but are not limited to, integrated circuit die 602 and at least one communication chip 608. In some implementations the communication chip 608 is fabricated as part of integrated circuit die 602. Integrated circuit die 602 may include CPU 604 as well as on-die memory 606, often used as cache memory, that can be provided by technologies such as embedded DRAM (eDRAM) or spin-transfer torque memory (STTM or STTM-RAM).

Computing device 600 may include other components that may or may not be physically and electrically coupled to the motherboard or fabricated within an SoC die. These other components include, but are not limited to, volatile memory 610 (e.g., DRAM), non-volatile memory 612 (e.g., ROM or flash memory), a graphics processing unit 614 (GPU), digital signal processor 616, crypto processor 642 (a specialized processor that executes cryptographic algorithms within hardware), chipset 620, antenna 622, display or touchscreen display 624, touchscreen controller 626, battery 628 or other power source, power amplifier (not shown), global positioning system (GPS) device 644, compass 630, motion coprocessor or sensors 632 (that may include an accelerometer, a gyroscope, and a compass), speaker 634, camera 636, user input devices 638 (such as a keyboard, mouse, stylus, and touchpad), and mass storage device 640 (such as hard disk drive, compact disk (CD), digital versatile disk (DVD), and so forth).

Communications chip 608 enables wireless communications for the transfer of data to and from computing device 600. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. Communication chip 608 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. Computing device 600 may include a plurality of communication chips 608. For instance, first communication chip 608 may be dedicated to shorter range wireless communications such as Wi-Fi and Bluetooth and a second communication chip 608 may be dedicated to longer range wireless communications such as GPS, EDGE, GPRS, CDMA, WiMAX, LTE, Ev-DO, and others.

Processor 604 of computing device 600 includes one or more devices, such as transistors or metal interconnects, that are formed in accordance with embodiments including metal to semiconductor interfaces as described to confine a low density of states metal. The term "processor" may refer to any device or portion of a device that processes electronic data from registers and/or memory to transform that electronic data into other electronic data that may be stored in registers and/or memory.

Communication chip 608 may also include one or more devices, such as transistors or metal interconnects, that are formed in accordance with embodiments including metal to semiconductor interfaces as described to confine a low density of states metal.

In further embodiments, another component housed within computing device 600 may contain one or more devices, such as transistors or metal interconnects, that are formed in accordance with implementations including metal to semiconductor interfaces as described to confine a low density of states metal.

In various embodiments, computing device 600 may be a laptop computer, a netbook computer, a notebook computer, an ultrabook computer, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, computing device 600 may be any other electronic device that processes data.

## Claims

1. An apparatus comprising:
a transistor comprising:
a gate dielectric (145) layer formed on a substrate (110);
a gate electrode (150) formed on the gate dielectric (145) layer;
a source (120) on one side of the gate electrode (150), a drain (130) on an opposite side of the gate electrode (150) and a channel (140) between the source (120) and drain (130), each of the source (120), drain (130) and channel (140) comprising semiconductor material; and
a contact (160, 170) to one of the source (120) and the drain (130), wherein the contact (160, 170) comprises a low density of states metal, having an interface of the metal and a semiconductor material of one of the source (120) and drain (130), and wherein the interface between the metal and the semiconductor material has a stepped profile,
**characterized in that** the contact area between the semiconductor material and the metal taken through a horizontal cross-section of the interface gets progressively smaller proceeding in a direction towards substrate (110),
wherein the low density of states metal is one of antimony, bismuth, or tin, or is an alloy of antimony, bismuth or tin.

2. The apparatus of claim 1, further comprising a dielectric material (180) on the transistor, wherein the contact is disposed through the dielectric material (180) and the contact area of the metal is confined in the dielectric material.

3. The apparatus of any of claims 1 to 2, wherein the semiconductor material comprises a heavily doped semiconductor material.

4. A method comprising forming the apparatus of any of claims 1 to 3, the method comprising:
confining the contact area of the semiconductor material; and
forming the metal contact in the contact area.

5. The method of claim 4, wherein confining the contact area comprises grading the contact area of the semiconductor material from a first area to a smaller second area.

6. The method of claim 4, wherein confining the contact area comprises forming an opening in a dielectric material (180).

7. The method of any of claims 4 to 6, wherein forming the metal comprises depositing the metal by a chemical thin film technique and annealing under an inert or reducing atmosphere.

## Patentansprüche

1. Vorrichtung, umfassend:
einen Transistor, umfassend:
eine Gate-Dielektrikumschicht (145), ausgebildet auf einem Substrat (110);
eine Gate-Elektrode (150), ausgebildet auf der Gate-Dielektrikumschicht (145);
eine Source (120) auf einer Seite der Gate-Elektrode (150), einen Drain (130) auf einer gegenüberliegenden Seite der Gate-Elektrode (150) und einen Kanal (140) zwischen der Source (120) und dem Drain (130), wobei Source (120), Drain (130) und Kanal (140) jeweils Halbleitermaterial umfassen; und
einen Kontakt (160, 170) zu entweder der Source (120) oder dem Drain (130), wobei der Kontakt (160, 170) ein Metall mit niedriger Zustandsdichte umfasst, eine Grenzfläche des Metalls und eines Halbleitermaterials von einem von Source (120) und Drain (130) aufweisend, und wobei die Grenzfläche zwischen dem Metall und dem Halbleitermaterial ein abgestuftes Profil aufweist,
**dadurch gekennzeichnet, dass** die Kontaktfläche zwischen dem Halbleitermaterial und dem Metall entlang eines horizontalen Querschnitts der Grenzfläche in Richtung zu dem Substrat (110) zunehmend kleiner wird,
wobei das Metall mit niedriger Zustandsdichte Antimon, Wismut oder Zinn ist oder eine Legierung von Antimon, Wismut oder Zinn ist.

2. Vorrichtung nach Anspruch 1, ferner umfassend ein dielektrisches Material (180) auf dem Transistor, wobei der Kontakt durch das dielektrische Material (180) hindurch angeordnet ist und die Kontaktfläche des Metalls in dem dielektrischen Material eingegrenzt ist.

3. Vorrichtung nach einem der Ansprüche 1 bis 2, wobei das Halbleitermaterial ein stark dotiertes Halbleitermaterial umfasst.

4. Verfahren, umfassend das Ausbilden der Vorrichtung nach einem der Ansprüche 1 bis 3, das Verfahren umfassend:
Eingrenzen der Kontaktfläche des Halbleitermaterials; und
Ausbilden des Metallkontakts in der Kontaktfläche.

5. Verfahren nach Anspruch 4, wobei das Eingrenzen der Kontaktfläche das Abstufen der Kontaktfläche des Halbleitermaterials von einer ersten Fläche zu einer zweiten, kleineren Fläche umfasst.

6. Verfahren nach Anspruch 4, wobei das Eingrenzen der Kontaktfläche das Ausbilden einer Öffnung in einem dielektrischen Material (180) umfasst.

7. Verfahren nach einem der Ansprüche 4 bis 6, wobei das Ausbilden des Metalls das Abscheiden des Metalls durch eine chemische Dünnschichttechnik und das Glühen unter einer inerten oder reduzierenden Atmosphäre umfasst.

## Revendications

1. Appareil comprenant :
un transistor comprenant :
une couche de diélectrique de grille (145) formée sur un substrat (110) ;
une électrode de grille (150) formée sur la couche de diélectrique de grille (145) ;
une source (120) sur un côté de l'électrode de grille (150), un drain (130) sur un côté opposé de l'électrode de grille (150) et un canal (140) entre la source (120) et le drain (130), la source (120), le drain (130) et le canal (140) comprenant chacun un matériau semi-conducteur ; et
un contact (160, 170) soit avec la source (120), soit avec le drain (130), dans lequel le contact (160, 170) comprend un métal à faible densité d'états, ayant une interface du métal et d'un matériau semi-conducteur soit de la source (120), soit du drain (130), et dans lequel l'interface entre le métal et le matériau semi-conducteur a un profil en gradins,
**caractérisé en ce que** la zone de contact entre le matériau semi-conducteur et le métal prise à travers une section transversale horizontale de l'interface devient progressivement plus petite en prenant une direction allant vers le substrat (110),
dans lequel le métal à faible densité d'états en est un parmi l'antimoine, le bismuth et l'étain, ou est un alliage d'antimoine, de bismuth et d'étain.

2. Appareil de la revendication 1, comprenant en outre un matériau diélectrique (180) sur le transistor, dans lequel le contact est disposé à travers le matériau diélectrique (180) et la zone de contact du métal est confinée dans le matériau diélectrique.

3. Appareil de l'une quelconque des revendications 1 à 2, dans lequel le matériau semi-conducteur comprend un matériau semi-conducteur fortement dopé.

4. Procédé comprenant la formation de l'appareil de l'une quelconque des revendications 1 à 3, le procédé comprenant :
le confinement de la zone de contact du matériau semi-conducteur ; et
la formation du contact métallique dans la zone de contact.

5. Procédé de la revendication 4, dans lequel le confinement de la zone de contact comprend la gradation de la zone de contact du matériau semi-conducteur d'une première zone à une deuxième zone plus petite.

6. Procédé de la revendication 4, dans lequel le confinement de la zone de contact comprend la formation d'une ouverture dans un matériau diélectrique (180).

7. Procédé de l'une quelconque des revendications 4 à 6, dans lequel la formation du métal comprend le dépôt du métal par une technique de film mince chimique et un recuit sous une atmosphère inerte ou réductrice.
